Europäisches Patentamt

(19) European Patent Office

Office européen des brevets

(11) Publication number : **0 330 196 B1**

(12) **EUROPEAN PATENT SPECIFICATION**

(45) Date of publication of patent specification :
**01.07.92 Bulletin 92/27**

(21) Application number : **89103176.7**

(22) Date of filing : **23.02.89**

(51) Int. Cl.⁵ : **C23C 4/10,** C04B 35/00

(54) **Subathmospheric pressure plasma spraying of superconductive ceramic.**

(30) Priority : **24.02.88 US 159998**

(43) Date of publication of application :
**30.08.89 Bulletin 89/35**

(45) Publication of the grant of the patent :
**01.07.92 Bulletin 92/27**

(84) Designated Contracting States :
**CH DE FR GB IT LI**

(56) References cited :
**EP-A- 0 286 135**
**EP-A- 0 324 121**
**DE-A- 2 155 217**
**US-A- 3 640 757**
**NEW SCIENTIST, nr. 1595, 14th January 1988,**
**page 42, New Science Publications, London,**
**GB: " Breakthrough in thin-filmsuperconduc-**
**tors"**

(73) Proprietor : **THE PERKIN-ELMER**
**CORPORATION**
**761 Main Avenue**
**Norwalk Connecticut 06859-0181 (US)**

(72) Inventor : **Reardon, Joseph D.**
**5 Power Place**
**Hauppauge, N.Y. 11788 (US)**
Inventor : **Rangaswamy, Subramaniam**
**348 Oxhead Road**
**Stony Brook, N.Y. 11790 (US)**
Inventor : **Simokos, Paul D.**
**108 Ridgecrest Road**
**Stamford, CT 06903 (US)**
Inventor : **Harrington, John H.**
**No.8 Points of View**
**Warwick, N.Y. 10990 (US)**

(74) Representative : **Patentanwälte Grünecker,**
**Kinkeldey, Stockmair & Partner**
**Maximilianstrasse 58**
**W-8000 München 22 (DE)**

EP 0 330 196 B1

Jouve, 18, rue Saint-Denis, 75001 PARIS

## Description

The present invention relates to a method of producing a superconductive ceramic article comprising maintaining a spray chamber at subatmospheric pressure, operating a plasma spray gun with a plasma-forming gas and introducing oxygen therein to produce a plasma spray stream directed towards a substrate in the spray chamber, and feeding a superconductive oxide ceramic composition into the spray stream such as to produce a ceramic article in the form of a super conductive oxide coating on the substrate.

Recent advances in the field of superconductors have particularly involved certain oxide ceramic compositions that exhibit superconductive properties at temperatures approaching liquid nitrogen temperature (77°K) and higher. The first announcement was by International Business Machines' Zurich Research Laboratory in April 1986 for the oxide composition of barium, lanthanum and copper.

Subsequently scientists at the University of Houston discovered a better composition consisting of yttrium oxide, barium oxide, and copper oxide in the atomic proportions 1,2,3 (and thereby known as "1-2-3 composition") with the nominal formula $YBa_2Cu_3O_{7-x}$. More broadly, an orthorhombic perovskite crystal structure has been recognized as the basis for superconductive oxides. The problem of preparing shapes and samples of such oxide materials immediately became apparent, and plasma spraying of coatings was recognized as a viable method. There have been numerous publications pertaining to these developments; typical references are as follows: "Superconductor Research Pace Quickens" G. Fisher and M. Schober, Ceramic Bul. 66, 1087 (1987); "Thermal Spraying Superconducting Oxide Coatings", J. P. Kirkland et al, Advanced Ceramic Materials 2, No. 3B Special Issue, 401 (1987).

However, realization of full potential for superconductive properties has remained elusive. The superconductivity has been incomplete and lacking in reproducibility. The problem of sufficient and reliable superconductivity, for example in plasma sprayed coatings, has been traced broadly to the quality of the superconductive powder utilized, particularly the stoichiometry of constitutents including oxygen and the presence of contaminants. Details are not very well understood. Superconductive ceramics such as the 1-2-3 type are particularly susceptible to reduction of the oxide. A further problem is that superconductivity is detrimentally sensitive to effects in grain boundaries which are inherent from the processing. Subsequent annealing of the material in oxygen helps, but with only some improvement.

In U.S. Patent No. 3,576,672 (Harris et al) there is disclosed a method for depositing a ferrite coating by means of an arc plasma torch with an oxygen shroud and/or oxygen carrier gas for the ferrite powder, in ordinary ambient atmosphere. Such a method may be utilized in the production of coatings of the 1-2-3 composition but, it is expected that the aforementioned problems will remain even after subsequent annealing in oxygen.

Plasma spraying at subatmospheric pressure in a spray chamber is known, as disclosed, for example, in U.S. Patent No. 3,839,618 (Muehlberger). It is stated therein that the source of plasma gas "is preferably argon or helium, although various other gases may be employed, for example to provide desired environmental conditions in the chamber". However, it is well known in the art of plasma spraying that the plasma-forming gas used for a practical plasma spray gun must be inert or reducing. Such chamber spraying is normally used for spraying metallic coatings without oxygen present in order to obtain oxygen-free coatings. Although suited for spraying metals, low pressure generally has the undesirable effect of reducing the oxygen content of oxide ceramic spray materials, and no real benefit appears to have been recognized. Therefore, oxides have not received significant attention in chamber spraying.

In EP-A-0 324 121 a method of producing a superconductive ceramic article as mentioned above has already been described according to Article 54 (3) EPC. According to said application, the oxygen is added to the gas operating the plasma-spray gun and the gas mixture is introduced into a bore of metal metallizing nozzle from a rear end portion thereof. The oxygen gas is added in an amount of at least 30 vol.% into the operating gas.

From the publication "New Scientist", no 1595, page 42, 1988, a method for producing a superconductive ceramic article has also been known in which a plasma-spray gun is used to produce a plasma-spray stream into which a superconductive oxide ceramic composition is fed and the spray stream directed towards the substrate in a spray chamber. Said spray chamber is retained at low pressure between 1/40 and 1/4 atmosphere and the chamber contains ambient gas which is admitted to the spray chamber.

Therefore, an object of the present invention is to provide a method of producing a superconductive oxide ceramic article with improved superconductive properties. A further object is to provide an improved method of plasma spraying to produce a superconductive ceramic oxide coating. An additional object is to provide an improved method of plasma spraying in a subatmospheric spray chamber. A further object of the present invention is to provide a plasma spraying system for producing superconductive oxide ceramic layers having improved superconducting properties. This will be achieved in accordance with the invention in that a partial pressure of oxygen in the spray chamber is selected, and that sufficient oxygen is introduced substantially at the exit end of the gun to maintain the selected partial pressure in the spray chamber.

In one embodiment the oxygen is introduced in the form of a shroud gas enveloping the spray stream.

According to another embodiment, the ceramic composition is in the form of a powder and the oxygen is introduced as a carrier gas for the powder.

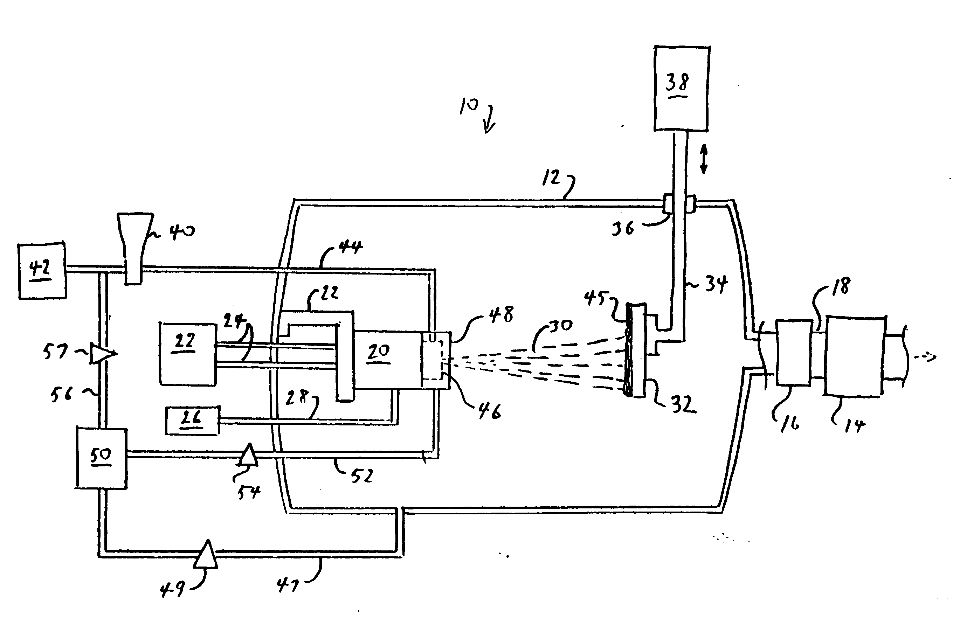

The drawing shows a schematic view of a system for carrying out the present invention.

With reference to the drawing, a low pressure plasma spraying system **10** includes a spray chamber 12 and a pumping system **14** for maintaining the spray chamber at subatmospheric pressure. A filter **16** is mounted in ducting **18** between the chamber and the pump for removing dust and free powder from the effluent to protect the pumping system. A plasma spray gun **20** is retained on a mounting **22** in the chamber. The gun, for example, is of the general type described in U.S. Patent No.3,145,287. Operational means for operating plasma spray gun **20** include a conventional power supply **22** to apply a DC arc current via cables **24** to the gun. The operational means also includes a source **26** of a plasma-forming gas which is directed through a tube **28** to gun **20** where the gas is heated by an internal arc to produce a plasma spray stream **30**. Plasma-forming gas is generally inert such as argon, helium and/or nitrogen. Coolant of water or the like is also supplied [by means not shown] to the gun through cables **24**. The subatmospheric chamber pressure is generally below about $933 \cdot 10^2$ Pa (700 torr to about $6,6 \cdot 10^2$ Pa (5 torr), preferably between $800 \cdot 10^2$ Pa (600) and $66 \cdot 10^2$ Pa (50 torr). At the low pressure very high velocity spraying is achieved in order to produce dense coating with minimized boundary effects between particles.

Spray stream **30** is directed towards a substrate **32** attached to a mounting **34** that leads slidingly through a sealing port **36** from a drive system **38** for imparting oscillatory motion to the substrate during spraying to obtain coverage over a desired surface area. Other axes of motion (not shown) may also be applied to substrate **32** and/or to plasma gun **20**. Feeding means include a powder feeder **40** for introducing spray powder entrained in a carrier gas from a carrier gas source **42** through tube **44** into spray stream **30** such as to produce a ceramic coating **45** on substrate **32**. The powder is directed into stream **30** just inside a gun nozzle **46** as shown, or outside the gun **20**, in the conventional manner. Substrate temperature is maintained in the range of 300 to 1500°C, preferably 700 to 1000°C, by spray traverse rate, spray rate, water cooling of the mounting (not shown), and/or cooling jets (not shown) of air, carbon dioxide or liquid nitrogen.

Substrate **32** is made of a material such as copper, nickel, cobalt and alloys thereof. The substrate is conventionally prepared by light grit blasting or other roughening and cleaning procedure, and further cleaning in a solvent such as acetone or etching with an etchant such as Schantz solution. Alternatively or additionally the substrate is coated with a metallic bond coat such as nickel-aluminum or nickel-chromium-aluminum-yttrium and/or with an oxide coating such as aluminum oxide, prior to the superconductive coating. Such a bond coat may be applied by plasma spraying in open air or in the chamber (without oxygen if appropriate). As a further alternative substrate **32** may be treated before, during, and/or after spraying in the chamber, by conventional transferred arc techniques are suggested in the aforementioned U.S. Patent No. 3,839,618.

According to the present invention oxygen is fed into chamber **12**, for example, via line **47** with valve **49** therein for adjusting oxygen pressure in the chamber. Preferably the oxygen is introduced into spray stream **30** at gun **20**. This may be effected through a shroud **48** positioned on the end of the gun coaxially with the nozzle **46** for enveloping the spray stream with oxygen. The shroud receives the oxygen from an oxygen source **50** via a tube **52**. An adjustable valve **54** in the tube line is desirable for adjusting oxygen flow. The shroud **48** is of the known or desired type, for example as described in U.S. Patent No. 3,470,347 (Jackson) for inert gas shrouding. The shrouding also may be effected by a gas ring (not shown) on the nozzle face with oxygen gas jets directed along the spray stream.

Alternatively, and more simply, there is no physical shroud and the oxygen is fed into the spray stream by way of utilizing oxygen introduced as the carrier gas via tube **56** and a valve **57** for conveying the powder. The carrier may be all oxygen or may comprise an inert gas to balance the amount of oxygen desired to effect the selected partial pressure as described below.

Further according to the present invention a superconductive type of oxide ceramic material in powder form is utilized as the spray powder. This material may be formed of the 1-2-3 composition or other superconductive type of oxide, particularly one that is susceptible to oxygen depletion during exposure to plasma stream temperatures at subatmospheric pressure. Powder is of conventional size, vis. -100 mesh +5 microns (-149 +5 microns), preferably -170 +325 mesh (-88 +44 microns) or, alternatively, -44 +5 microns.

Sufficient oxygen is introduced into spray chamber **12** to maintain a selected partial pressure of the oxygen in the chamber during the spraying operation. The selected partial pressure of oxygen is best determined by simple experimentation, because such pressure will depend on the other selected parameters including type of gun and its operating conditions, chamber pressure and the powder composition and size. The experimenting may be effected by selecting successive partial pressures of the oxygen, producing corresponding coating compositions with the successive partial pressures, measuring for a corresponding degree of superconductivity of each of the corresponding coating compositions, determining optimum superconductivity from the corresponding degrees of superconductivity, and selecting an optimum partial pressure of oxygen correlated with the optimum degree of superconductivity. Generally the partial pressure oxygen should be in the range of about 10% to 50% of the total chamber pressure including the plasma gas.

Before measuring for superconductivity it may be necessary or at least desirable to anneal the sprayed coating in oxygen. This is done at several temperature levels programmed with time periods to effect the appropriate crystal structure with uniformity and to establish the proper proportion of oxygen content in the crystal lattice. However, it is contemplated that optimum selection of oxygen partial pressure with respect to other parameters may alleviate the need for an annealing step, or at least shorten the time thereof. Annealing, if needed, is effected in an oxygen-containing furnace in the conventional manner. The partial pressure of oxygen is in the range of 0.2 (air) to 1.0 (pure oxygen) and the annealing temperature is 890°C to 950°C. Annealing time is 2 to 45 hours at temperature followed by slow cooling at 1-2°C/min. Specifics are selected so as to form a friable mass of particles of the desired crystal structure and with substantially full oxidation. For example, annealing is done in pure oxygen at 930°C for 5 hours.

There are several known methods for measuring for the superconducting property of the coating article, including Meissner effect, and measurements of critical current Jc, temperature Tc and magnetic susceptibility Hc. Alternately, the preferred crystal structure may be determined by X-ray diffraction. A desirable method is simply observation of the Meissner effect. This technique is relatively straightforward in that the coating is observed to levitate above a magnet when cooled in liquid nitrogen. This experiment shows that the coating is, in fact, a high Tc superconductor with an onset temperature above 77K (liquid nitrogen temperature). The measurement is effected at an appropriate temperature for superconductivity, such as with liquid nitrogen, or with a varying temperature to determine superconducting transition point (Tc).

Examples of spraying parameters for 1-2-3 composition powder of -44 +5 microns are given in the Table herein. Coatings about 0.5mm thick are sprayed onto a substrate of stainless steel prepared by light grit blasting with fine alumina grit, using Metco plasma guns sold by The Perkin-Elmer Corporation, Westbury, N. Y.

**TABLE**

| Gun (Metco Model No.) | 7MB | 9MB | 9MB |
|---|---|---|---|
| Nozzle | 700 | 700 | 700 |
| Gas | Ar/$N_2$ | $N_2$ | Ar/He |
| Gas Pressure to Gun (bar) | 6.7 | 3.3 | 3.3 |
| Gas Flow (l/min) | 10/1.9 | 12.5 | 18.7/9.4 |
| Current (amperes) | 1100 | 1100 | 1070 |
| Voltage | 54 | 55 | 56 |
| Power (kw) | 60 | 60 | 60 |
| Powder Feeder (Metco Model No.) | 3MP | 4MP | 4MP |
| Carrier Gas | $O_2$ | $O_2$ | $O_2$ |
| Flow (l/min) | 2 | 2 | 2 |
| Pressure (bar) | 0.5 | 2.7 | 2.7 |
| Feed Rate (kg/hr) | 2.7 | 2.7 | 2.7 |
| Spray Pressure (torr) | 50 | 300 | 600 |
| Spray Distance (cm) | 40 | 25 | 11.5 |

In each case excellent coatings are obtained which are very dense with virtually nil discernable particle boundaries due to the spraying at high velocity at low pressure, as well as the elevated substrate temperature and display a high degree of super- conductivity. Generally coatings ranging in thickness from about 25 microns to 0.5 cm or even thicker may be obtained. The coatings may be removed from the substrate for free standing use. Applications are any that may be associated with supercondoctive materials, particularly of the "high temperature" type. These include electrical conductors, magnets and electromagnetic sensors, and may be incorporated into solid state devices soch as Josephson junctions.

## Claims

1. A method of producing a superconductive ceramic article comprising maintaining a spray chamber at subatmospheric pressure, operating a plasma spray gun with a plasma- forming gas and introducing oxygen therein to produce a plasma spray stream directed towards a substrate in the spray chamber, and feeding a superconductive oxide ceramic composition into the spray stream such as to produce a ceramic article in the form of a super conductive oxide coating on the substrate,
**characterised in that**
a partial pressure of oxygen in the spray chamber is selected, and that sufficient oxygen is introduced substantially at the exit end of the gun to maintain the selected partial pressure in the spray chamber.

2. A method according to Claim 1 wherein the oxygen is introduced in the form of a shroud gas enveloping the spray stream.

3. A method according to Claim 1 wherein the ceramic composition is in the form of a powder and the oxygen is introduced as a carrier gas for the powder.

4. A method according to Claim 1 wherein the subatmospheric pressure is between about $66.10^2$ Pa and $800.10^2$ Pa (50 and 600 torr).

5. A method according to Claim 4 wherein the partial pressure of the oxygen is between about 10% to 50% of the subatmospheric pressure.

6. A method according to Claim 1 wherein the plasma forming gas is an inert gas.

7. A method according to Claim 1 wherein the ceramic composition is in the form of a powder.

8. A method according to Claim 1 further comprising selecting successive partial pressures of the oxygen, producing corresponding ceramic articles with the successive partial pressures, measuring for a corresponding degree of superconductivity of each of the corresponding ceramic articles, determining optimum superconductivity from the corresponding degrees of superconductivity, and selecting an optimum partial pressure of oxygen correlated with the optimum degree of superconductivity.

9. A method according to Claim 1 wherein the ceramic composition is formed of yttrium oxide, barium oxide, and copper oxide in atomic proportions of 1:2:3.

## Patentansprüche

1. Ein Verfahren zum Erzeugen eines supraleitenden Keramikgegenstandes, welches umfaßt:
Halten einer Sprükammer unter einem Druck unterhalb des Atmosphärendrucks, betreiben einer Plasmasprüheinrichtung mit einem plasmabildenden Gas und Einführen von Sauerstoff dort hinein, um einen Plasmasprühstrahl zu erzeugen, der auf ein Substrat in der Sprühkammer gerichtet ist, und Zuführen einer supraleitenden Oxidkeramikzusammensetzung in den Sprühstrahl, um so einen Keramikgegenstand in der Form eines supraleitenden Oxidüberzugs auf dem Substrat zu erzeugen,
**dadurch gekennzeichnet,** daß
ein Partialdruck des Sauerstoffs in der Sprühkammer ausgewählt wird, und daß genügend Sauerstoff im wesentlichen an dem Ausgangsende der Sprüheinrichtung eingeführt wird, um den ausgewählten Partialdruck in der Sprükammer aufrechtzuerhalten.

2. Ein Verfahren nach Anspruch 1, wobei der Sauerstoff in der Form eines den Sprühstrahl einhüllenden Abschirmgases zugeführt wird.

3. Ein Verfahren nach Anspruch 1, wobei die Keramikzusammensetzung in der Form eines Pulvers und der Sauerstoff als ein Trägergas für das Pulver eingeführt wird.

4. Ein Verfahren nach Anspruch 1, wobei der Druck unterhalb des Atmosphärendrucks zwischen $66,10^2$ Pa und $800,10^2$ Pa (50 und 600 Torr) liegt.

5. Ein Verfahren nach Anspruch 4, wobei der Partialdruck des Sauerstoffs zwischen 10 bis 50% des Drucks unterhalb des Atmosphärendrucks liegt.

6. Ein Verfahren nach Anspruch 1, wobei das plasmabildende Gas ein Inertgas ist.

7. Ein Verfahren nach Anspruch 1, wobei die Keramikzusammensetzung in der Form eines Pulvers vorliegt.

8. Ein Verfahren nach Anspruch 1, welches ferner das Auswählen aufeinanderfolgender Partialdrucke des Sauerstoffs, das Erzeugen entsprechender Keramikgegenstände mit den aufeinanderfolgenden Partialdrukken, das Messen eines entsprechenden Grades der Supraleitfähigkeit von jedem der entsprechenden Keramikgegenstände, das bestimmen der optimalen Supraleitfähigkeit aus den entsprechenden Graden der Leitfähigkeit, und das Auswählen eines optimalen Partialdrucks des Sauerstoffs, der mit dem optimalen Grad der Leitfähigkeit korreliert, umfaßt.

9. Ein Verfahren nach Anspruch 1, wobei die Keramikzusammensetzung aus Yttriumoxid, Bariumoyid, und Kupferoxid in den atomaren Verhältnissen 1:2:3 gebildet wird.


**Revendications**

1. Méthode de production d'une céramique supraconductrice, comprenant le maintien à la pression subatmosphérique d'une chambre de diffusion, l'utilisation d'un pistolet pulvérisateur de plasma avec un gaz formant plasma et l'introduction d'oxygène dedans, pour produire un jet de diffusion de plasma dirigé vers un substrat dans la chambre de diffusion, et la fourniture d'une composition de céramique oxydée supraconductrice dans la chambre de diffusion, de manière à produire une céramique sous la forme d'un revêtement oxydé supraconducteur sur le substrat
caractérisée en ce que
une pression d'oxygène partielle est choisie dans la chambre de diffusion, et en te qu'une quantité suffisante d'oxygène est introduite sensiblement à l'extrémité de sortie du pistolet, de manière à maintenir la pression partielle choisie, dans la chambre de diffusion.

2. Méthode selon la revendication 1, dans laquelle l'oxygène est introduit sous la forme d'un gaz de protection enveloppant le jet de pulvérisation.

3. Méthode selon la revendication 1 dans laquelle la composition céramique a la forme d'une poudre, et l'oxygène est introduit comme gaz de transport pour la poudre.

4. Méthode selon la revendication 1, dans laquelle la pression subatmosphérique est comprise entre $66.10^2$ Pa et $800.10^2$ Pa (50 et 600 torr).

5. Méthode selon la revendication 4 dans laquelle la pression partielle d'oxygène est comprise entre environ 10 pour cent et 50 pour cent de la pression atmosphérique.

6. Méthode selon la revendication 1, dans laquelle le gaz formant le plasma est un gaz inerte.

7. Méthode selon la revendication 1, dans laquelle la composition céramique est sous forme de poudre.

8. Méthode selon la revendication 1, comprenant en outre le choix de pressions partielles suivantes de l'oxygène, la production de céramiques correspondant avec les pressions partielles suivantes, la mesure d'un degré de supraconductivité correspondant pour chacune des céramiques correspondantes, la détermination de la supraconductivité optimale à partir des degrés de supraconductivité correspondants, et le choix de la pression partielle d'oxygène optimale, par rapport au degré de supraconductivité optimal.

9. Méthode selon la revendication 1, dans laquelle la composition céramique est formée d'oxyde d'yttrium, d'oxyde de baryum, et d'oxyde de cuivre, dans les proportions atomiques de 1:2:3.